# EUROPEAN PATENT APPLICATION

(11) **EP 4 804 753 A1**
(43) Date of publication of application: **09.09.2026**
(21) Application number: 26159475.8
(22) Date of filing: 19.02.2026
(51) Int. Cl.: H10D 30/00, H10D 62/10

(54) **SEMICONDUCTOR ELECTRONIC DEVICE WITH IMPROVED EDGE TERMINATION STRUCTURE AND MANUFACTURING PROCESS**

(30) Priority: 28.02.2025 IT 202500004188
(71) Applicant: STMicroelectronics International N.V., 1228 Plan-les-Ouates, Geneva (CH)
(72) Inventor: MURABITO, Domenico, 20864 Agrate Brianza (MB) (IT)
(74) Representative: Studio Torta S.p.A.

(57) **Abstract**

A semiconductor electronic device (10) has: a semiconductor body (11) of a first conductivity type (N), that has a front surface (11A) and a back surface (11B) at a distance from the front surface along a first direction (Z), and a lateral edge (12); an active area (13) that accommodates, in use, a conductive channel of the electronic device; and an edge termination structure (30) alongside the active area, between the active area and the lateral edge along a second direction (X) transversal to the first direction (Z). The edge termination structure has: deep regions (32) of a second conductivity type (P) different from the first conductivity type and arranged in the semiconductor body, extending up to a first depth from the front surface along the first direction, and at a distance from each other along the second direction; discontinuous doped portions (34) of the second conductivity type, arranged at the front surface, at a distance from each other along the second direction and extending up to a second depth lower than the first depth; and a continuous doped region (35) of the second conductivity type, arranged at the front surface, between the active area and the plurality of discontinuous doped portions along the second direction.

## Description

### Technical Field

The present invention relates to a semiconductor electronic device, in particular a superjunction vertically-conducting device, with an improved edge termination structure, and to the manufacturing process thereof.

### Background

As is known, semiconductor electronic devices (e.g., MOSFET transistors) used in power applications need to be able to withstand high voltages.

In power applications, a high breakdown voltage and a low on-state resistance are parameters desired in order to improve the electrical performance of the electronic devices.

In this regard, the electronic devices are designed so as to have structures increasingly closer to each other and epitaxial layers with increasingly higher dopant concentrations.

Furthermore, as is known, power devices have an edge termination structure which surrounds the active area of the semiconductor device, that is arranged between the active area and the external lateral edge of the semiconductor device.

The edge termination structure comprises doped regions that optimize the distribution of the electric field within the semiconductor body of the power device.

As a result of lowering the on-state resistance, the concentration of the doped regions of the edge termination structure also needs to increase, in particular in superjunction devices as they are based on the charge balance principle. In fact, the charge balance principle of superjunction devices entails a decrease in the efficiency of the edge termination structures traditionally adopted, because of the electric fields being focused only in one part of the same structure instead of being distributed.

The Applicant has observed that the edge termination structures of known semiconductor devices, in particular superjunction devices, are not able to provide sufficiently high performance and have high manufacturing costs.

The aim of the present invention is to overcome the drawbacks of the prior art.

### Summary

According to the present invention, a semiconductor electronic device and a manufacturing process thereof are provided, as defined in the attached claims.

### Brief Description of the Drawings

For a better understanding of the present invention, embodiments thereof are now described, purely by way of nonlimiting example, with reference to the attached drawings, wherein:
- Figure 1 shows a cross-section of a superjunction semiconductor device with corresponding edge termination, according to one embodiment;
- Figure 2 shows an enlarged portion of the semiconductor device of Figure 1;
- Figures 3A-3B show successive manufacturing steps of the device of Figure 1, according to one embodiment; and
- Figures 4A-4D show successive manufacturing steps of the device of Figure 1, according to a different embodiment.

### Description of Embodiments

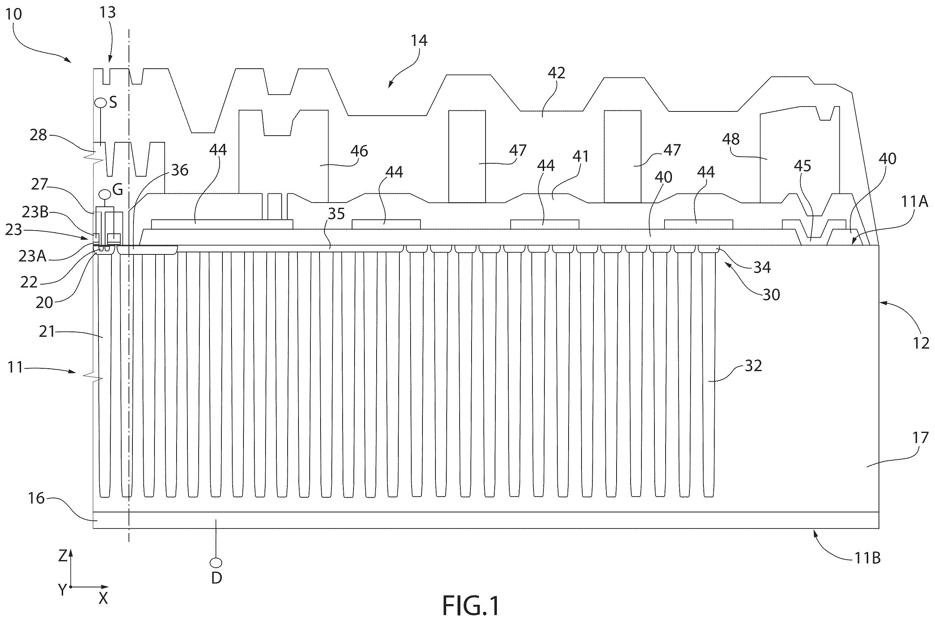

Figure 1 shows a semiconductor electronic device, hereinafter referred to simply as device 10, in a Cartesian reference system XYZ having axes X, Y, Z orthogonal to each other.

The device 10 is a silicon-based semiconductor device; however, the device 10 may be a semiconductor device based on a different material, such as silicon carbide or another simple or compound semiconductor material.

The device 10 may be an electronic device for power applications.

The device 10 is formed in a die that may be obtained after a dicing step of a semiconductor wafer.

In detail, the device 10 comprises a semiconductor body 11 having an edge 12 that physically delimits the semiconductor body 11. In practice, the edge 12 is a lateral edge that laterally delimits the semiconductor body 11.

The device 10 comprises an active area 13 and an edge area 14 that extends around the active area 13.

In top-plan view, not shown here, the edge area 14 surrounds the active area 13 and is arranged between the active area 13 and the lateral edge 12.

In particular, the edge area 14 extends in structural continuity with the active area 13.

Typically, the active area 13 may extend in a central portion of the semiconductor body 11, and the edge region 14 in a peripheral portion of the semiconductor body 11.

The active area 13 is configured to accommodate, in use, a conductive channel of the device 10.

The edge area 14 may comprise, in the semiconductor body 11, functional elements adapted to reduce or prevent crowding of the electric field lines outside the active area 13, as better described and illustrated below. In practice, the edge area 14 is configured not to accommodate, in use, a conductive channel of the device 10.

In the embodiment shown, the device 10 is a superjunction device, that is based on the charge balance principle; in particular, the device 10 is a vertically conducting MOSFET device. However, the device 10 may be a vertically conducting device of a different type, such as for example a transistor of a different type, a diode, and the like.

Figure 1 shows only one portion of the active area 13, in particular a portion of the active area 13 in proximity to the edge area 14. A dash-dot line separates the active area 13 from the edge area 14 in Figure 1; the dash-dot line is to be understood as qualitative.

The semiconductor body 11 has a front surface 11A and a back surface 11B at a distance from each other along the Z-axis.

The front surface 11A forms the front side of the semiconductor body 11 and delimits it at the top. The back surface 11B forms the rear side of the semiconductor body 11 and delimits it at the bottom.

In practice, the front surface 11A and the back surface 11B are opposite to each other along the Z-axis.

The semiconductor body 11 is also delimited laterally by the lateral edge 12, that extends at a distance from the active area 13 along the X-axis. In a manner not shown here, the lateral edge 12 also extends at a distance from the active area 13 along the Y-axis.

In practice, the lateral edge 12 may physically delimit the semiconductor body 11, for example on planes transversal to those of the front 11A and back 11B surfaces.

In detail, in the embodiment shown, the semiconductor body 11 comprises a substrate 16 and a structural region 17 extending on the substrate 16. For example, the structural region 17 may be grown epitaxially on the substrate 16; consequently, in the following the structural region 17 is also referred to as epitaxial region 17.

The epitaxial region 17 forms, in the active area 13, a drift region of the device 10.

Substrate 16 and epitaxial region 17 may be of the same semiconductor material, for example silicon, and have the same conductivity type (here N).

The substrate 16 may have a higher doping level than the epitaxial region 17.

The regions arranged within the active area 13 may vary as a function the specific type of the device 10 (transistor, diode, etc.).

In particular, the active area 13 may comprise a plurality of elementary cells.

For simplicity, in Figure 1, only one portion of the elementary cells that may be included within the active area 13 is shown.

In detail, in the embodiment shown, the device 10 comprises, in the active area 13, surface body regions 20 of the P-type; deep body regions 21 of the P-type; source regions 22 of the N-type; and gate regions 23.

The surface body regions 20 extend from the front surface 11A in the semiconductor body 11, in particular in the epitaxial region 17. In a manner not shown here the surface body regions may extend at a distance from each other along axis X and/or Y.

The source regions 22 extend, at least in part, each within a respective surface body region 20.

The deep body regions 21 extend, along the Z-axis, in depth in the semiconductor body 11, in particular in the epitaxial region 17, each starting from a respective surface body region 20.

The deep body regions 21 extend at a distance from the front surface 11A, in direct contact with the surface body regions 20.

In practice, the deep body regions 21 extend in the semiconductor body 11 up to a depth, measured from the front surface 11A along the Z-axis, greater than the depth, measured from the front surface 11A along the Z-axis, of the surface body regions 20.

The deep body regions 21 may have a width (along the X-axis in the section of Figure 1) lower than the width (along the X-axis in the section of Figure 1) of the surface body regions 20.

The gate regions 23 comprise an insulating gate portion 23A and a conductive gate portion 23B and extend on the front surface 11A partially superimposed on the surface body regions 20 along the Z-axis.

A drain region of conductive material, not shown here, extends at the back surface 11B forming a drain terminal D of the device 10.

In practice, in use, the surface body regions 20 are configured to accommodate the conductive channel of the device 10, thus forming a conductive path extending along the Z-axis through the semiconductor body 11, between the front surface 11A and the back surface 11B, through the drift region formed by the epitaxial region 17.

An insulating region 27 extends on the front surface 11A of the semiconductor body 11.

A conductive region 28 extends on the semiconductor body 11, in electrical contact with the source regions 22. In practice, the conductive region 28 is a source contact region and forms a source terminal S of the device 10. In particular, the conductive region 28 extends through openings of the insulating region 27, throughout the thickness of the insulating region 27, up to the front surface 11A.

The conductive region 28 may be used, for example at sections of the device 10 not shown here, to also contact the surface body regions 20, so as to obtain a body-source short circuit.

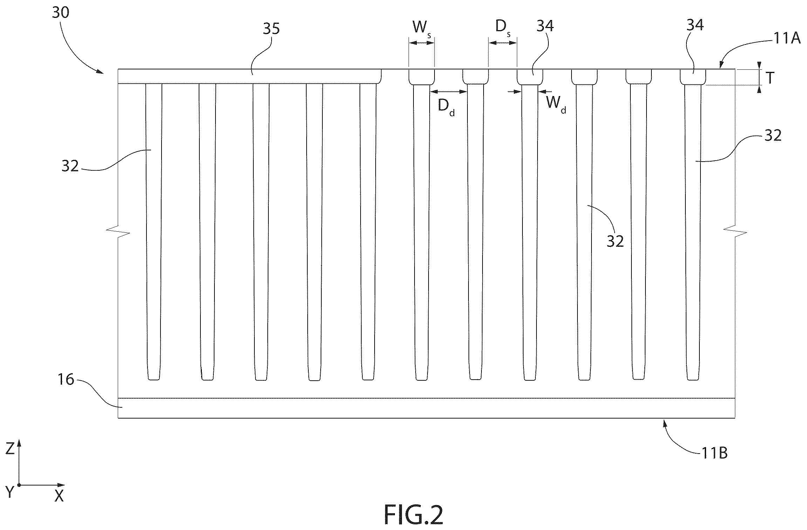

The device 10 comprises, in the edge area 14, an edge termination structure or region 30 that extends within the semiconductor body 11 around the active area 13, and of which an enlarged portion is shown in Figure 2.

The edge termination structure 30 comprises a plurality of deep regions 32, of P-type in the example considered, that extend at a distance one from the other between active area 13 and lateral edge 12 (e.g., along the X-axis in Figure 1), in depth in the semiconductor body 11.

In particular, the deep regions 32 may extend from each other at a distance D_{d} comprised for example between 1 µm and 6 µm. The distance D_{d} may indicate the minimum distance between two adjacent deep columns 32; that is, in the embodiment shown, the distance between respective portions more proximate to the front surface 11A.

In detail, the deep regions 32 extend, along the Z-axis, within the epitaxial region 17, towards the substrate 16, starting from a distance T from the front surface 11A. The distance T may be comprised for example between 15 µm and 60 µm, in particular of about 40 µm.

In practice, the deep regions 32 are deep columns that may be arranged at a distance from the front surface 11A.

The deep regions 32 have a width W_{d}, measured along the direction between the active area 13 and the lateral edge 12, that is along the X-axis in the section of Figure 1, comprised for example between 0.1 µm and 5 µm, in particular of about 2.0 µm.

In particular, the width W_{d} may indicate the maximum width of the deep columns 32; that is, in the embodiment shown, the width of the respective portions more proximate to the front surface 11A.

In the embodiment shown, the deep regions 32 have decreasing width moving along the Z-axis, towards the substrate 16. In other words, the deep regions 32 are sloped columns.

The deep regions 32 may have a concentration of doping species comprised for example between 1·10¹⁵ atoms/cm³ and 2.10¹⁸ atoms/cm³, in particular of 1.0·10¹⁶ atoms/cm³. The concentration of doping species may be, along the Z-axis, homogeneous or non-homogeneous, depending on the specific application.

In top-plan view, not shown here, all or some of the deep regions 32 may form closed regions around the active area 13, for example concentric to each other and/or with respect to the deep body regions 21.

The edge termination structure 30 further comprises a discontinuous surface region 34, extending at the front surface 11A, and formed by a plurality of portions (still indicated by 34 in the following) distinct from each other and arranged at a distance from each other between the active area 13 and the lateral edge 12 (e.g., along the X-axis in Figure 1).

The discontinuous portions 34 extend at a distance Dₛ from each other comprised for example between 0.3 µm and 5 µm, in particular of about 0.5 µm.

The discontinuous portions 34 each extend at a respective deep region 32, in contact therewith. In practice, a respective deep region 32 that extends starting from the lower portion of the respective discontinuous portion 34, along the Z-axis, towards the back surface 11B may correspond to each discontinuous portion 34.

In particular, in the embodiment shown, each discontinuous portion 34 extends facing along the Z-axis on a respective deep region 32, in contact therewith.

In particular, along the X-axis, each discontinuous portion 34 may be in contact with only one deep region 32.

The discontinuous portions 34 each have a width Wₛ, measured along the direction between active area 13 and lateral edge 12 (i.e. along the X-axis in Figure 1), greater than the width of the respective deep region 32; for example, the width of the discontinuous portions 34 may be comprised between 0.15 µm and 9 µm, in particular 3.0 µm. The fact that the width Wₛ of the discontinuous portions 34 is greater than the width W_{d} of the deep regions 32 may allow to obtain, in use, both a high voltage withstanding of the device 10 and an optimized distribution of the electric field.

In particular, the deep regions 32 may be arranged, along the X axis, each centered with respect to a respective discontinuous portion 34. This feature may allow to optimize the distribution of the electric field over the entire length of the edge, avoiding concentration at certain points with a consequent lowering of the breakdown voltage.

The width Wₛ of the discontinuous portions 34 may be indicative of the maximum (superficial) width of the discontinuous portions 34, that is measured at the front surface 11A.

The discontinuous portions 34 may have a concentration of doping species, comprised for example between 1·10¹⁵ atoms/cm³ and 1·10¹⁷ atoms/cm³, for example 5·10¹⁶ atoms/cm³, different from that of the deep regions 32; this may allow to optimize the performance in use of the device 10.

In particular, the discontinuous portions 34 may have a lower concentration of doping species than the deep regions 32; this may allow the distribution of the electric field, in use, in the semiconductor body 11 to be optimized across the entire width of the edge, avoiding a concentration in certain points with a consequent lowering of the breakdown voltage. Therefore, the device 10 may have further optimized performance.

Referring again to Figure 1, the edge termination structure 30 also comprises a continuous surface region, formed in this embodiment by two continuous portions 35, 36 contiguous to each other, arranged at the front surface 11A, between the active area 13 and the discontinuous surface region 34.

The portions 35, 36 have a different conductivity from the epitaxial region 17, that is they are of P-type in the example shown.

The continuous portion 36 may have a concentration of doping species comprised, for example, between 5·10¹⁵ atoms/cm³ and 1·10¹⁹ atoms/cm³, for example 5·10¹⁸ atoms/cm³, and the continuous portion 35 may have a concentration of doping species comprised, for example, between 1·10¹⁵ atoms/cm³ and 1·10¹⁷ atoms/cm³, for example 5·10¹⁶ atoms/cm³; in particular, the doping level of the continuous portion 35 may be lower than the doping level of the continuous portion 36. This allows to optimize the electric field distribution in the semiconductor body 11, as may emerge for example from dynamic tests wherein the device is subject to stress in dV/dt.

In addition or alternatively, the continuous portion 36, arranged between the active area 13 and the continuous portion 35, may have a concentration of doping species higher than the surface body regions 20 and/or the deep body regions 21. This feature, in combination with the feature that the continuous portion 35 may have a concentration of doping species equal to that of the discontinuous portions 34, may allow further optimization of the distribution of the electric field, in use, in the semiconductor body 11, as may emerge, for example, from dynamic tests in which the device is subjected to stress in dV/dt.

The continuous portion 36 extends in proximity to the active area 13. In the embodiment shown, the continuous portion 36 may also extend partially within the active area 13, depending on the specific application and layout.

The continuous portions 35, 36 extend starting from the front surface 11A, along the Z-axis, toward the back surface 11B. The continuous portion 35 may extend in the epitaxial region 17 up to a depth lower than the continuous portion 36.

The continuous portion 35 has a width, measured along the direction between the active area 13 and the lateral edge 12, that is along the X-axis in Figure 1, such that it extends continuously over, in particular in contact with, multiple deep portions 32.

For example, the continuous portion 35 may have a width comprised between 30 µm and 100 µm, for example of 60 µm.

In the embodiment shown, the continuous portion 35 extends in the semiconductor body 11 starting from the front surface 11A up to the depth T. This may allow the device 10 to maintain low manufacturing costs.

The continuous portion 35 may have a concentration of doping species higher than or equal to the discontinuous doped portions 34; this may optimize the distribution of the electric field in the semiconductor body 11.

The device 10 may also comprise additional elements useful for the operation of the same device 10, whose structure, layout, etc. depend on the specific typology of the device 10.

In detail, the device 10 comprises an insulating structure that extends on the front surface 11A and comprises, in this embodiment, an insulating region 40 that extends on the front surface 11A, in contact therewith, and over at least part of the edge termination structure 30; an insulating region 41 that extends over (in contact with) and surrounds the first insulating region 40; and an insulating region 42 that extends over (in contact with) and surrounds the insulating region 41.

Conductive regions 44, for example of polysilicon, may extend on the insulating region 40, in particular in contact therewith, at a distance from each other along the X-axis and above the edge termination structure 30. In a manner not shown, the conductive regions 44 may be electrically connected to each other so as to form an equipotential region.

The conductive regions 44 act as field plate regions and may be floating.

A conductive region 45, for example of polysilicon, may extend, through an opening of the insulating region 40, in contact (or not in contact) with the front surface 11A, in proximity to the lateral edge 12 (that is, between the edge termination structure 30 and the lateral edge 12).

A metal region 46 may extend between the insulating regions 41, 42, and in contact with the conductive regions 44. The metal region 46 may be, for example, the contact region of the gate terminal G and may be used, in use, also to bias the conductive regions 44.

Further metal regions 47 extend over the insulating region 41, above the edge termination structure 30 at a distance from each other and in particular offset (staggered) with respect to the conductive regions 44.

The metal regions 47 may be floating.

A metal region 48 may extend on the insulating region 41, above the conductive portion 45, in particular in electrical contact therewith in a manner not shown here. The metal region 48 may be used in use to bias the conductive region 45 and form an equipotential ring in proximity to the lateral edge 12 of the device 10, or be floating.

The presence of the continuous surface region 35 between the active area 13 and the discontinuous surface portions 34, that is the fact that the continuous surface region 35 is arranged at a shorter distance from the active area 13 than the discontinuous surface portions 34, allows the device 10 to obtain a high breakdown voltage, in use, and therefore high performance.

The Applicant has verified that the fact that the discontinuous doped portions 34 are each in contact with a respective deep region 32 (and in particular facing along the Z-axis) allows to further improve the performance of the device 10 and to optimize the design of the device 10.

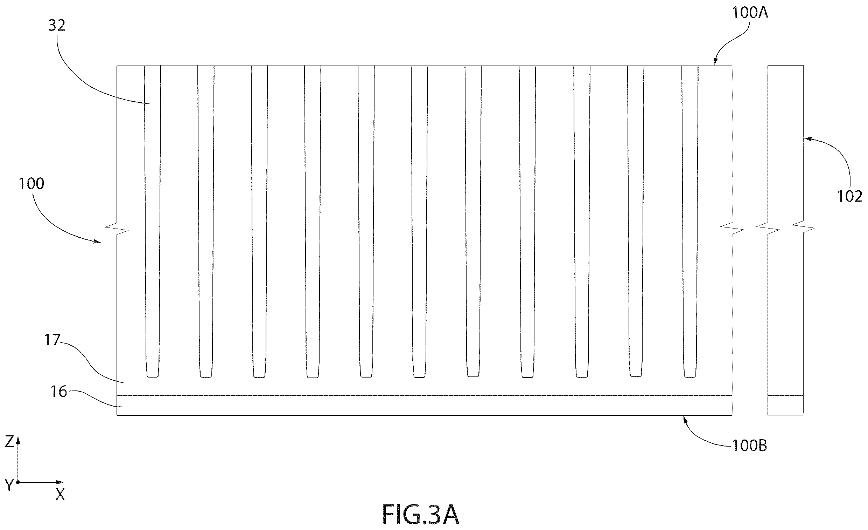

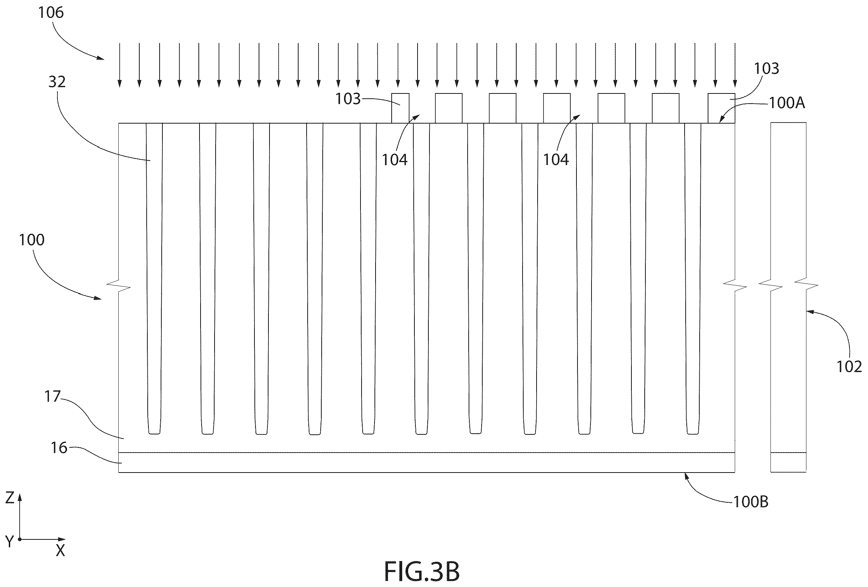

With reference to Figures 3A and 3B, a manufacturing process of the device 10 of Figure 1 is described hereinafter, with reference to manufacturing steps relating to the edge termination structure 30 and in particular to the enlarged portion of Figure 2.

Figure 3A shows a portion of a wafer 100 of semiconductor material having a front surface 100A and a back surface 100B, wherein the epitaxial region 17 and the deep columns 32 have already been formed.

The wafer 100 also has a lateral surface 102, transversal to the surfaces 100A, 100B and corresponding to a lateral edge of the device 10 (for example to the lateral edge 12) obtainable following the dicing of the wafer 100. The lateral surface 102 may be an internal surface of the wafer 100 or a surface that externally delimits the wafer 100, depending on the position of the portion of wafer wherein the device 10 is formed.

The deep columns 32 may be formed by trenching and successive epitaxial filling starting from the front surface 100A of the wafer 100, or by implanting doping species starting from the front surface 100A of the wafer 100.

The deep columns 32 may be formed concurrently with the formation of the epitaxial region 17; for example, by repeated steps of epitaxial growth and ion implantation.

Furthermore, according to one embodiment, the deep regions 32 may be formed concurrently with the deep body regions 21.

In Figure 3B, a mask 103 is formed on the front surface 100A of the wafer 100. The mask 103 comprises a plurality of portions, again indicated by 103, spaced from each other in such a way as to form a plurality of discontinuous openings 104 and a continuous opening 105.

The discontinuous openings 104 extend above the deep regions 32, in particular aligned therewith along the X-axis, where it is desired to form the discontinuous surface portions 34.

The continuous opening 105 extends above the deep regions 32 wherein it is desired to form the continuous surface portion 35.

Successively, again with reference to Figure 3B, an ion implantation of doping species, represented by arrows 106, is performed on the front surface 100A.

The ion implantation may have a dose comprised for example between 5·10¹¹ atoms/cm² and 6·10¹² atoms/cm², for example 5·10¹² atoms/cm².

In this manner, ion implantation allows both the discontinuous surface region 34 and the continuous surface region 35 to be formed concurrently.

Further manufacturing steps, known per se and therefore not shown here, may then follow for forming the device 10 of Figure 1.

The manufacturing process described above allows the edge termination structure 30 to be manufactured, while maintaining the manufacturing costs of the device 10 low.

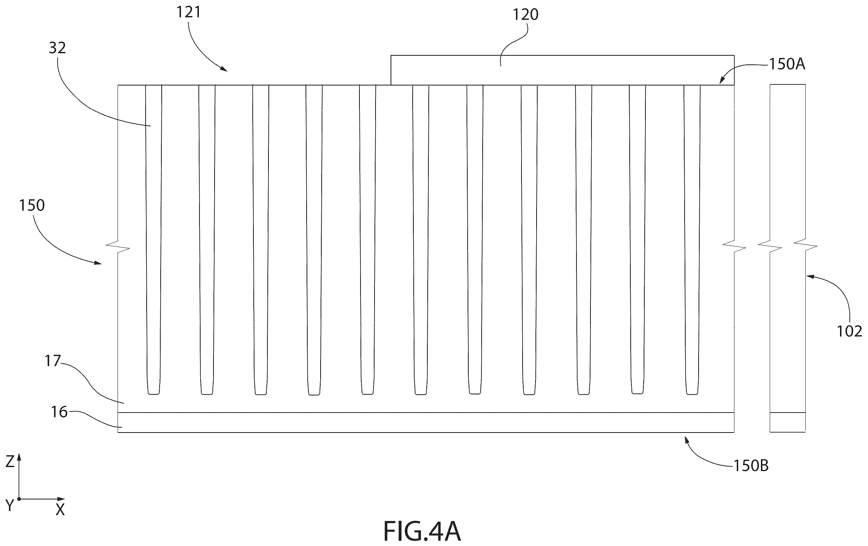

With reference to Figures 4A-4D, a different embodiment of the manufacturing process of the edge structure 30 is described.

Unlike the process of Figures 3A-3B, a mask 120 is formed on the front surface 150A (Figure 4A) of a wafer 150 of semiconductor material, for forming the continuous surface region 35 of the edge termination structure 30.

The mask 120 covers the portion of the front surface 150A wherein the discontinuous surface region 34 is indented to be formed and has an opening 121 that exposes the portion of the front surface 150A wherein the continuous portion 35 is intended to be formed.

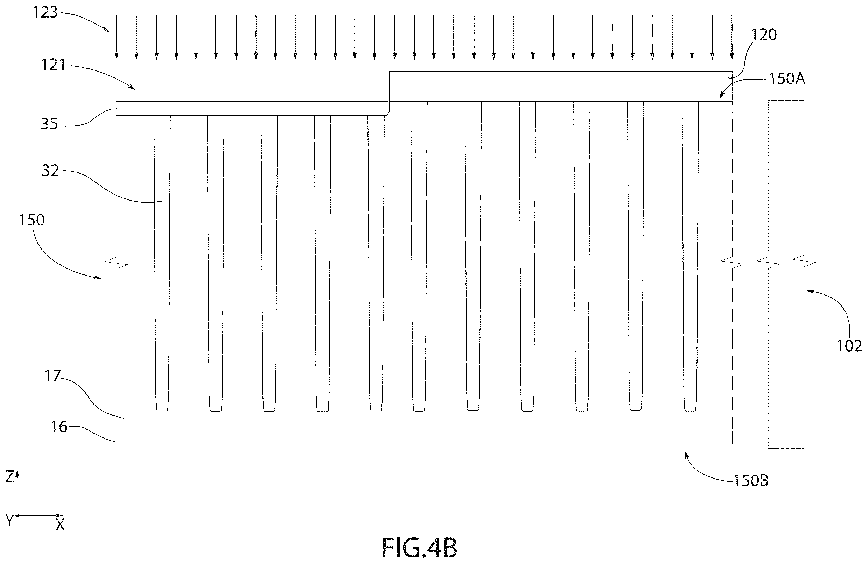

Successively, Figure 4B, an ion implantation is performed, represented by arrows 123, that leads to the formation of the continuous portion 35. The implantation of Figure 4B may have a dose comprised between 5·10¹¹ atoms/cm² and 7·10¹² atoms/cm², for example of 6·10¹² atoms/cm².

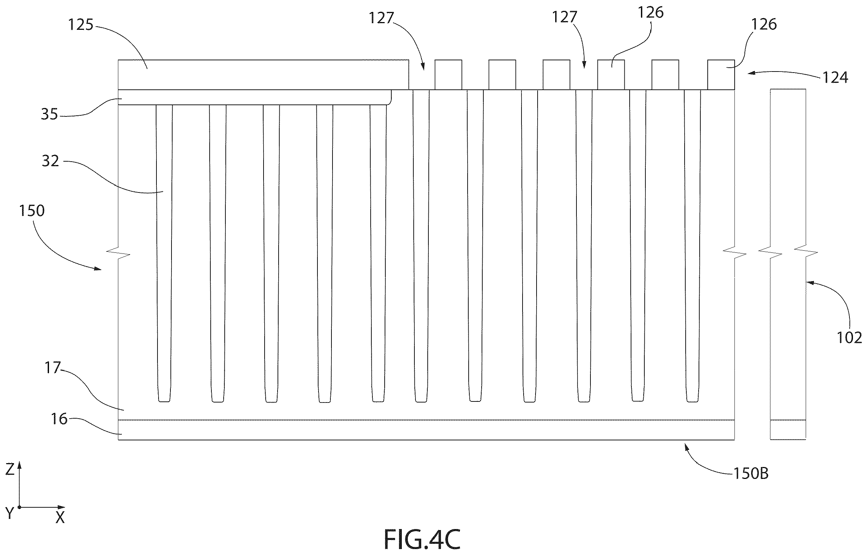

The mask 120 is removed and, Figure 4C, a mask 124 is formed on the front surface 150A comprising a continuous portion 125, that extends above the continuous portion 35, and a plurality of discontinuous portions 126 alongside the continuous portion 125 toward the lateral edge 12.

The mask 124 comprises openings 127 that expose portions of the front surface 150A at the deep regions 32 wherein it is desired to form the discontinuous surface portions 34 of Figures 2.

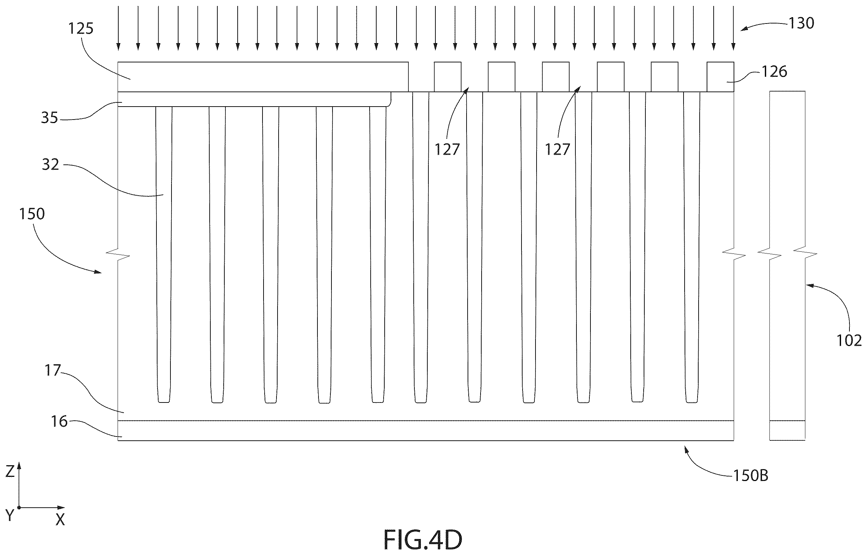

Then, Figure 4D, an ion implantation, represented by arrows 130, is performed which leads to the formation of the discontinuous portions 34. The implantation of Figure 4D may have a different dose than that of Figure 4B. In particular, the implantation of Figure 4D may have a lower dose than the dose used for the implantation of Figure 4B; for example, the implantation of Figure 4D may have a dose comprised between 5·10¹¹ atoms/cm² and 7·10¹² atoms/cm², for example of 6·10¹¹ atoms/cm².

The fact of using two distinct masks 120 and 124 for forming the continuous portion 35 and, respectively, the discontinuous portions 34, allows to obtain a high flexibility during the design step.

Finally, it is clear that modifications and variations may be made to the semiconductor electronic device and the manufacturing processes thereof described and illustrated herein without thereby departing from the scope of the present invention, as defined in the attached claims.

For example, the deep regions 32 may be strips. This may allow charge equilibrium to be achieved simultaneously in both the active area 13 and the edge area 14.

For example, the edge termination structure may have a number and distribution of pockets (wells) different from what has been described.

According to one embodiment, the discontinuous doped portions 34 may interrupt, moving along the X-axis towards the lateral edge 12, before the deep regions 32. In practice, the last deep region 32 (that is, the one closest to the lateral edge 12 along the X-axis) may be arranged, along the X-axis, at a shorter distance from the lateral edge 12 than the last discontinuous portion 34 (that is, the one closest to the lateral edge 12 along the X-axis). This may optimize the distribution of the electric field over the entire length of the edge, avoiding concentration at certain points with a consequent lowering of the breakdown voltage.

For example, the discontinuous portions 34 may each be aligned with a respective deep region 32, but have widths different from each other along the X-axis.

For example, the deep regions 32 may have a constant width W_{d} along the Z-axis, that is they may not be of the sloped type, depending on the specific application and/or the specific manufacturing process used.

For example, the doped regions 32, 34, 35, 36 of the edge termination structure 30 may be manufactured, alternatively or in addition to successive steps of epitaxial growth and implantation of doping species, by forming trenches and filling the trenches with doped semiconductor material.

For example, in case the electronic device is a MOSFET transistor, the gate regions 23 may be of the trench type, that is extending along the Z-axis in the semiconductor body 11.

For example, the active area 13 may also accommodate elementary cells of devices other than a MOSFET, depending on the specific application of the semiconductor electronic device.

For example, the present invention also applies to a superjunction semiconductor electronic device other than a MOSFET, such as for example trenchFETs, diodes, triristors, MESFETs, MISFETs, IGBTs, etc.

The conductivity types, P and N, may be reversed with respect to what has been discussed above. For example, the semiconductor body may be of the P-type and the doped regions of the edge termination structure may be of the N-type.

Finally, the different embodiments described and illustrated above may be combined to provide further solutions.

## Claims

1. A semiconductor electronic device (10) comprising:
a semiconductor body (11) having a first conductivity type (N), a front surface (11A) and a back surface (11B) extending at a distance from the front surface along a first direction (Z), the semiconductor body further having a lateral edge (12);
an active area (13) configured to accommodate, in use, a conductive channel of the semiconductor electronic device; and
an edge termination structure (30) alongside the active area, between the active area and the lateral edge of the semiconductor body along a second direction (X) transversal to the first direction (Z),
wherein the edge termination structure comprises:
a plurality of deep regions (32) having a second conductivity type (P) different from the first conductivity type, extending in the semiconductor body (11) up to a first depth from the front surface (11A) along the first direction (Z), at a distance from each other along the second direction (X) ;
a plurality of discontinuous doped portions (34) having the second conductivity type (P), arranged at the front surface (11A) of the semiconductor body (11), at a distance from each other along the second direction (X), and extending in the semiconductor body up to a second depth (T) from the front surface (11A) along the first direction (Z), the second depth being lower than the first depth; and
a continuous doped region (35) having the second conductivity type (P) and arranged at the front surface (11A) of the semiconductor body (11), between the active area (13) and the plurality of discontinuous doped portions (34) along the second direction (X).

2. The semiconductor electronic device according to the preceding claim, wherein each discontinuous doped portion (34) is in contact with a respective deep region (32) that extends in the semiconductor body (11), along the first direction (Z), starting from the respective discontinuous doped portion (34).

3. The semiconductor electronic device according to claim 1 or 2, wherein each discontinuous doped portion (34) faces, parallel to the first direction (Z), a respective deep region (32).

4. The semiconductor electronic device according to any of the preceding claims, wherein the continuous doped region (35) extends along the second direction (X) in such a way as to face two or more of the deep regions (32) that extend in the semiconductor body (11), along the first direction (Z), starting from the continuous doped region (35).

5. The semiconductor electronic device according to any of the preceding claims, wherein the discontinuous doped portions (34) have a doping level equal to the continuous doped region (35).

6. The semiconductor electronic device according to any of the preceding claims, wherein the discontinuous doped portions (34) have a doping level different from, in particular lower than, the deep regions (32).

7. The semiconductor electronic device according to any of the preceding claims, wherein the continuous doped region (35) is a first continuous doped region, the edge termination structure further comprising a second continuous doped region (36) having the second conductivity type (P) and arranged at the front surface (11A) of the semiconductor body (11), between the active area (13) and the first continuous doped region (35) along the second direction (X), wherein the second continuous doped region (36) has a higher doping level than the first continuous doped region (35) and/or a higher doping level than a body region (20) of the active area (13).

8. The semiconductor electronic device according to any of the preceding claims, wherein the discontinuous doped portions (34) extend one from the other at a distance (Dₛ) comprised between 0.3 µm and 5.0 µm and/or each have a width (Wₛ), along the second direction (X), comprised between 0.15 µm and 9.0 µm.

9. The semiconductor electronic device according to any of the preceding claims, wherein the continuous doped region (35) has a width, along the second direction (X), comprised between 30 µm and 100 µm.

10. The semiconductor electronic device according to any of the preceding claims, wherein the deep regions (32) each have a width (W_{d}), along the second direction (X), comprised between 0.1 µm and 5.0 µm and/or extend from each other at a distance (D_{d}) comprised between 1.0 µm and 6.0 µm.

11. The semiconductor electronic device according to any of the preceding claims, wherein the deep regions (32) have a maximum width (W_{d}) along the second direction (X) and the discontinuous portions (34) have a maximum width (Wₛ) along the second direction (X), the maximum width of the deep regions being lower than the maximum width of the discontinuous portions, and wherein the deep regions (32) are arranged, along the second direction (X), each centered with respect to a respective discontinuous portion (34).

12. The semiconductor electronic device according to any of the preceding claims, wherein the discontinuous doped portions (34) end, along the second direction (X) towards the lateral edge (12), before the deep regions (32).

13. The semiconductor electronic device according to any of the preceding claims, wherein the device is a superjunction device, in particular a superjunction MOSFET device comprising at least one deep body region (21) extending in the active area (13) at a distance from the front surface (11A) along the first direction (Z).

14. A process of manufacturing a semiconductor electronic device, comprising:
providing a wafer (100; 150) of semiconductor material having a first conductivity type (N), a front surface (100A; 150A) and a back surface (100B; 150B) at a distance from the front surface along a first direction (Z);
forming an active area (13) configured to accommodate, in use, a conductive channel of the semiconductor electronic device; and
forming an edge termination structure (30) extending alongside the active area, between the active area and a lateral surface (102) of the wafer that is indicative of a lateral edge of the semiconductor electronic device, along a second direction (X) transversal to the first direction (Z),
wherein forming an edge termination structure comprises:
forming, starting from the front surface (100A; 150A) of the wafer, a plurality of deep regions (32) having a second conductivity type (P) different from the first conductivity type, extending in the wafer up to a first depth from the front surface along the first direction (Z), at a distance from each other along the second direction (X);
forming, in the wafer, a plurality of discontinuous doped portions (34) having the second conductivity type (P) and arranged at the front surface (100A; 150A) of the wafer, at a distance from each other along the second direction (X), extending in the wafer up to a second depth (T) from the front surface along the first direction (Z), the second depth being lower than the first depth; and
forming, in the wafer, a continuous doped region (35) having the second conductivity type (P) and arranged at the front surface (100A; 150A) of the wafer, between the active area (13) and the plurality of discontinuous doped portions (34) along the second direction (X).

15. The manufacturing process according to the preceding claim, wherein the discontinuous doped portions (34) and the continuous doped region (35) are formed using a same mask (103) and/or a same implantation (106) of doping species,
or wherein forming the continuous doped region (35) comprises forming a first mask (120) and performing a first implantation (123) of doping species; and wherein forming the discontinuous doped portions (34) comprises forming a second mask (124) different from the first mask and performing a second implantation (130) of doping species.
